# EUROPEAN PATENT APPLICATION

(11) **EP 4 773 789 A1**
(43) Date of publication of application: **08.07.2026**
(21) Application number: 23950666.0
(22) Date of filing: 28.08.2023
(51) Int. Cl.: H10N 60/12, H10N 60/01, H10N 60/10

(54) **QUANTUM BIT DEVICE AND METHOD FOR MANUFACTURING QUANTUM BIT DEVICE**

(71) Applicant: FUJITSU LIMITED, Kawasaki-shi, Kanagawa 211-8588 (JP)
(72) Inventor: HIROSE, Shinichi, Kawasaki-shi, Kanagawa 211-8588 (JP); KAWANO, Hiroyasu, Kawasaki-shi, Kanagawa 211-8588 (JP); KOUMA, Norinao, Kawasaki-shi, Kanagawa 211-8588 (JP)
(74) Representative: Haseltine Lake Kempner LLP
(86) International application number: PCT/JP2023/031059
(87) International publication number: WO 2025/046715

(57) **Abstract**

A quantum bit device includes a substrate, a quantum bit provided on a first surface of the substrate, a first conductive film provided on the first surface of the substrate, a through via that penetrates the substrate and is electrically connected to the first conductive film, and an anchor structure portion provided in the substrate around the through via and connected to a conductive film.

## Description

### FIELD

The disclosed technology relates to a quantum bit device and a manufacturing method of the quantum bit device.

### BACKGROUND

As a technology related to an electronic device having a through via, the following technology is known. For example, Patent Document 1 discloses a substrate provided with a through hole or a non-through hole extending from one surface toward the other surface, in which the hole includes a portion where a hole diameter in a thickness-direction cross-section of the substrate is enlarged relative to a hole diameter at the surface of the substrate. The through hole or the non-through hole is filled with a conductive material.

Patent Document 2 discloses that a GaAs substrate is etched to form a via hole, and Au is deposited in a via hole 111 by vapor deposition or plating to form a back electrode.

### Prior Art Document

### Patent Literature

Patent Document 1: Japanese Patent Application Laid-Open (JP-A) No. 2005-183548
Patent Document 2: Japanese Patent Application Laid-Open (JP-A) No. S63-193545

### SUMMARY OF INVENTION

### Technical Problem

In a superconducting quantum bit device in which a quantum bit is mounted on a substrate, a structure enabling input and output of a signal from a back surface of the substrate by utilizing a through via has been proposed. In a case in which there are a plurality of through vias in the substrate, the thickness of a resist formed on the substrate tends to vary. For example, when the film thickness of the resist varies when patterning of wiring, a quantum bit, or the like is performed, there is a possibility that the processing size is affected, and as a result, the characteristic variation of the quantum bit increases.

In order to solve the above problem, it is conceivable to planarize a surface of the substrate by covering an opening end of a through via with a conductive film that constitutes wiring or the like. However, in this case, in a manufacturing process of a quantum bit device, there is a possibility that the conductive film peels off at a portion of the conductive film that covers the opening end of the through via due to water pressure or air pressure inside the through via, for example, in a cleaning process.

The disclosed technology has been made in view of the above points, and an object thereof is to suppress peeling of a conductive film covering an opening end of a through via in a quantum bit device having the through via.

### Solution to Problem

A quantum bit device according to the disclosed technology includes a substrate, a quantum bit provided on a first surface of the substrate, a first conductive film provided on the first surface of the substrate, a through via that penetrates the substrate and is electrically connected to the first conductive film, and an anchor structure portion provided in the substrate around the through via and connected to the first conductive film.

### Advantageous Effects of Invention

According to the disclosed technology, in a quantum bit device having a through via, it becomes possible to suppress peeling of a conductive film that covers an opening end of the through via.

### BRIEF DESCRIPTION OF DRAWINGS

Fig. 1 is a partial equivalent circuit diagram of a quantum bit device according to an embodiment of the disclosed technology.
Fig. 2 is a diagram illustrating an example of a connection configuration of a plurality of quantum bits included in the quantum bit device according to the embodiment of the disclosed technology.
Fig. 3 is a schematic cross-sectional view illustrating an example of a configuration of the quantum bit device according to the embodiment of the disclosed technology.
Fig. 4 is a cross-sectional view illustrating an example of a configuration around a through via of the quantum bit device according to the embodiment of the disclosed technology.
Fig. 5A is a plan view illustrating an example of a shape and arrangement of an anchor structure portion in plan view according to the embodiment of the disclosed technology.
Fig. 5B is a plan view illustrating an example of a shape and arrangement of the anchor structure portion in plan view according to the embodiment of the disclosed technology.
Fig. 5C is a plan view illustrating an example of a shape and arrangement of the anchor structure portion in plan view according to the embodiment of the disclosed technology.
Fig. 6 is an enlarged cross-sectional view illustrating the anchor structure portion according to the embodiment of the disclosed technology.
Fig. 7 is an enlarged cross-sectional view illustrating the anchor structure portion according to the embodiment of the disclosed technology.
Fig. 8A is a cross-sectional view illustrating an example of a manufacturing method of the quantum bit device according to the embodiment of the disclosed technology.
Fig. 8B is a cross-sectional view illustrating an example of the manufacturing method of the quantum bit device according to the embodiment of the disclosed technology.
Fig. 8C is a cross-sectional view illustrating an example of the manufacturing method of the quantum bit device according to the embodiment of the disclosed technology.
Fig. 8D is a cross-sectional view illustrating an example of the manufacturing method of the quantum bit device according to the embodiment of the disclosed technology.
Fig. 8E is a cross-sectional view illustrating an example of the manufacturing method of the quantum bit device according to the embodiment of the disclosed technology.
Fig. 8F is a cross-sectional view illustrating an example of the manufacturing method of the quantum bit device according to the embodiment of the disclosed technology.
Fig. 8G is a cross-sectional view illustrating an example of the manufacturing method of the quantum bit device according to the embodiment of the disclosed technology.
Fig. 8H is a cross-sectional view illustrating an example of the manufacturing method of the quantum bit device according to the embodiment of the disclosed technology.
Fig. 8I is a cross-sectional view illustrating an example of the manufacturing method of the quantum bit device according to the embodiment of the disclosed technology.
Fig. 8J is a cross-sectional view illustrating an example of the manufacturing method of the quantum bit device according to the embodiment of the disclosed technology.
Fig. 8K is a cross-sectional view illustrating an example of the manufacturing method of the quantum bit device according to the embodiment of the disclosed technology.
Fig. 8L is a cross-sectional view illustrating an example of the manufacturing method of the quantum bit device according to the embodiment of the disclosed technology.
Fig. 8M is a cross-sectional view illustrating an example of the manufacturing method of the quantum bit device according to the embodiment of the disclosed technology.

### DESCRIPTION OF EMBODIMENTS

Hereinafter, an example of an embodiment of the disclosed technology will be described with reference to the drawings. In the drawings, the same or equivalent components and portions are denoted by the same reference numerals, and redundant description is omitted.

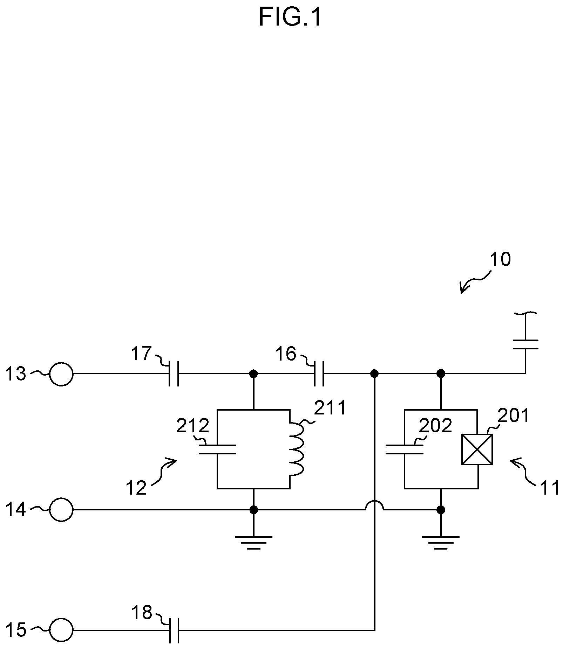

Fig. 1 is a partial equivalent circuit diagram of a quantum bit device 10 according to an embodiment of the disclosed technology. The quantum bit device 10 includes a quantum bit 11, a resonator 12, a read port 13, a ground port 14, and a control port 15.

The quantum bit 11 is an element that forms a coherent 2-level system using superconductivity, and includes a transmon in which a Josephson device 201 and a capacitor 202 are connected in parallel. The Josephson device 201 includes a pair of superconductors that exhibits superconductivity at a temperature equal to or lower than a predetermined critical temperature, and an ultrathin insulator having a thickness of about several nm sandwiched between the pair of superconductors. The superconductor may be, for example, aluminum, and the insulator may be, for example, aluminum oxide.

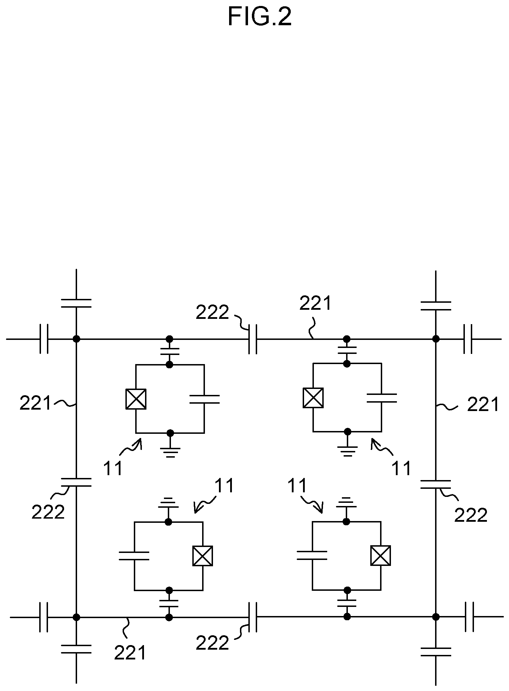

Fig. 2 is a diagram illustrating an example of a connection configuration of a plurality of quantum bits 11 included in the quantum bit device 10. In the quantum bit device 10, the plurality of quantum bits 11 are connected to respective adjacent other quantum bits 11 via an interbit wiring 221. A capacitor 222 is provided on the path of the interbit wiring 221. As a result, each of the quantum bits 11 creates a quantum entangled state with another adjacent quantum bit 11 and performs a quantum operation.

By the resonator 12 interacting with the quantum bit 11, a response signal indicating the state of the quantum bit 11 is read out. The resonator 12 is connected to the quantum bit 11 via a capacitor 16. The resonator 12 includes a resonance circuit in which a superconducting inductor 211 and a capacitor 212 are connected in parallel.

The read port 13, the ground port 14, and the control port 15 are access ports for accessing a quantum operation circuit including the quantum bit 11 and the resonator 12 from the outside. The read port 13 is connected to the resonator 12 via a capacitor 17. The read port 13 is used to extract a response signal indicating the state of the quantum bit 11 to the outside. The ground port 14 is connected to the quantum bit 11 and the resonator 12. The ground port 14 is used to apply a ground potential to the quantum bit 11 and the resonator 12 from the outside. The control port 15 is connected to the quantum bit 11 via a capacitor 18. The control port 15 is used to control the quantum bit 11 from the outside.

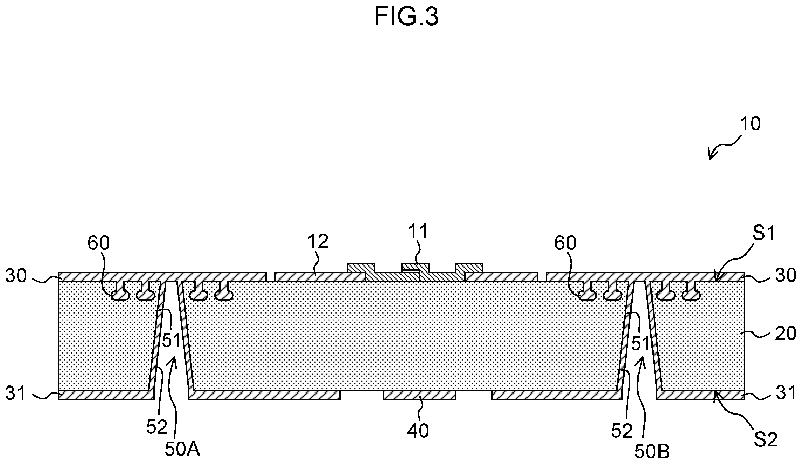

Fig. 3 is a schematic cross-sectional view illustrating an example of a configuration of the quantum bit device 10. Fig. 3 illustrates a peripheral region of one quantum bit 11. The quantum bit device 10 includes a substrate 20. The substrate 20 may be, for example, a silicon substrate.

The quantum bit 11 and the resonator 12 are provided on a first surface S1 of the substrate 20. The resonator 12 is formed by patterning a conductive film 30 provided on the first surface S1 of the substrate 20. Various wirings formed by patterning the conductive film 30 are provided on the first surface S1 of the substrate. The conductive film 30 is made of a superconductor such as TiN. The conductive film 30 is an example of a "first conductive film" in the disclosed technology.

A control electrode 40 functioning as the control port 15 is provided on a second surface S2 of the substrate 20 opposite to the first surface S1. The control electrode 40 is disposed immediately below the quantum bit 11, and a control signal supplied to the control electrode 40 is transmitted to the quantum bit 11 via the substrate 20. The control electrode 40 is formed by patterning a conductive film 31 provided on the first surface S2 of the substrate 20. Various wirings formed by patterning the conductive film 31 are provided on the second surface S2 of the substrate 20. The conductive film 31 is made of a superconductor such as TiN.

The quantum bit device 10 has through vias 50A and 50B penetrating the substrate. The through via 50A electrically connects the conductive film 30 provided on the first surface S1 of the substrate 20 and the conductive film 31 provided on the second surface S2 of the substrate 20. The through via 50A functions as the read port 13, and the through via 50B functions as the ground port 14. The through vias 50A and 50B have a conductive film 52 that covers the inner wall of a through hole 51 penetrating the substrate 20. The conductive film 52 is made of a superconductor such as TiN. Hereinafter, in a case in which the through vias 50A and 50B are not distinguished from each other or in a case in which they are collectively referred to, they are referred to as a "through via 50". The conductive film 52 is an example of a "fourth conductive film" in the disclosed technology.

The opening end of the through via 50 on the first surface S1 side is covered with the conductive film 30 provided on the first surface S1 of the substrate 20, and the opening is closed. On the other hand, the through via 50 is open on the second surface S2 side.

The quantum bit device 10 includes an anchor structure portion 60 for suppressing peeling of the conductive film 30. The anchor structure portion 60 is provided around the through via 50 inside the substrate 20, and has one end connected to the conductive film 30. In other words, the conductive film 30 is connected to the anchor structure portion 60 around the portion that covers the opening end of the through via 50.

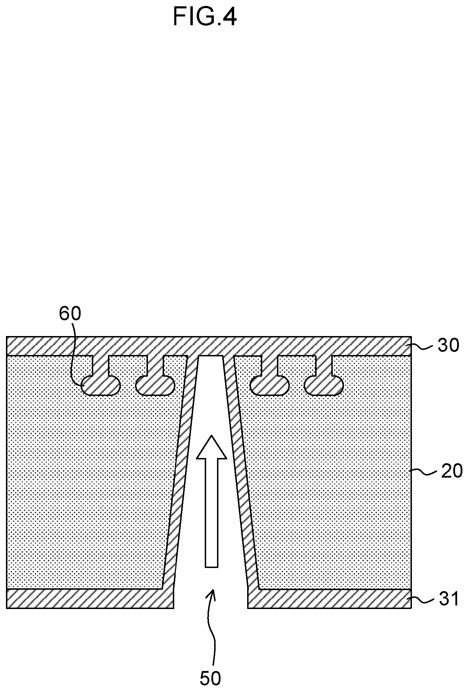

For example, in a manufacturing process of the quantum bit device 10, when flowing water enters the through via 50, as illustrated in Fig. 4, an upward force acts on the portion of the conductive film 30 that covers the opening end of the through via 50, as illustrated in Fig. 4. As a result, the conductive film 30 may be peeled off. The upward force caused by flowing water is merely one example of a cause of peeling of the conductive film 30, and the upward force may also be generated by other factors. By connecting the anchor structure portion 60 to the periphery of the portion of the conductive film 30 that covers the opening end of the through via 50, bonding between the conductive film 30 and the substrate 20 is strengthened, and peeling of the conductive film 30 is suppressed. The anchor structure portion 60 has an overhang shape in which the width on the deep side of the substrate 20 is greater than the width on the surface layer side of the substrate 20. That is, the anchor structure portion 60 has an expansion portion having a widened width on the deep side of the substrate 20. Since the anchor structure portion 60 has the overhang shape, the bonding between the conductive film 30 and the substrate 20 can be further strengthened. The shape of the anchor structure portion 60 is not limited to the overhang shape, and may be a wedge shape in which the deep side is pointed, or may be a cylindrical shape or a prismatic shape in which the widths of the deep side and the surface layer side are uniform.

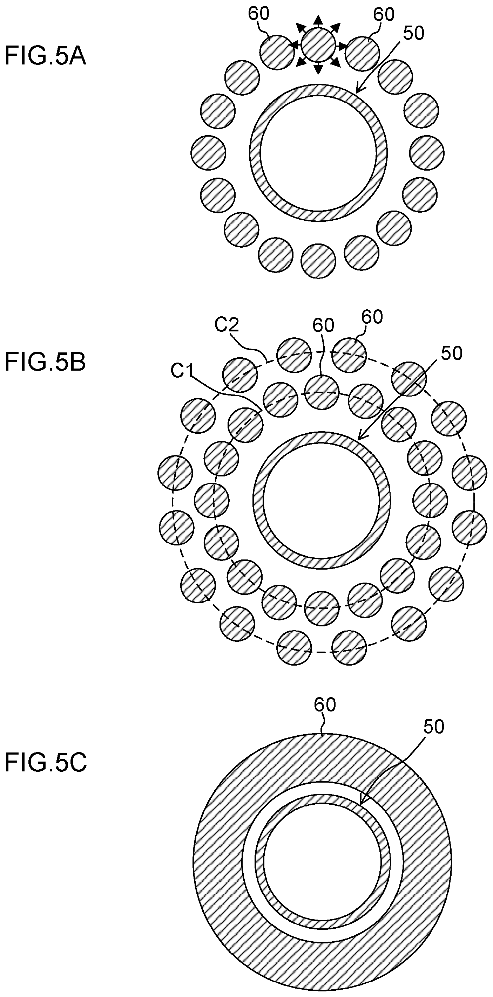

Fig. 5A is a plan view illustrating an example of a shape and arrangement of the anchor structure portion 60 in plan view. A plurality of anchor structure portions 60 may be provided in an arrangement surrounding the periphery of the through via 50. Since the plurality of anchor structure portions 60 are provided in the arrangement surrounding the periphery of the through via 50, the function of enhancing the bonding between the conductive film 30 and the substrate 20 by the anchor structure portion 60 can be effectively exhibited in the peripheral portion of the through via 50 where the risk of peeling of the conductive film 30 is high.

The shape of each of the plurality of anchor structure portions 60 (expansion portions) in plan view is preferably circular. By making the shape of the anchor structure portion 60 in plan view circular, as indicated by an arrow in Fig. 5A, an upward force (see Fig. 4) acting on a portion of the conductive film 30 that covers the opening end of the through via 50 can be radially and uniformly dispersed.

Fig. 5B is a plan view illustrating another example of the arrangement of the anchor structure portion 60 in plan view. As illustrated in Fig. 5B, a plurality of anchor structure portions 60 may be provided on the circumference of a first circle C1 surrounding the periphery of the through via 50 and on the circumference of a second circle C2 surrounding the periphery of the first circle C1. By disposing the plurality of anchor structure portions 60 in a multiple manner as described above, the effect of suppressing the peeling of the conductive film 30 can be enhanced.

Fig. 5C is a plan view illustrating another example of the shape of the anchor structure portion 60 in plan view. The anchor structure portion 60 may have an annular shape surrounding the periphery of the through via 50.

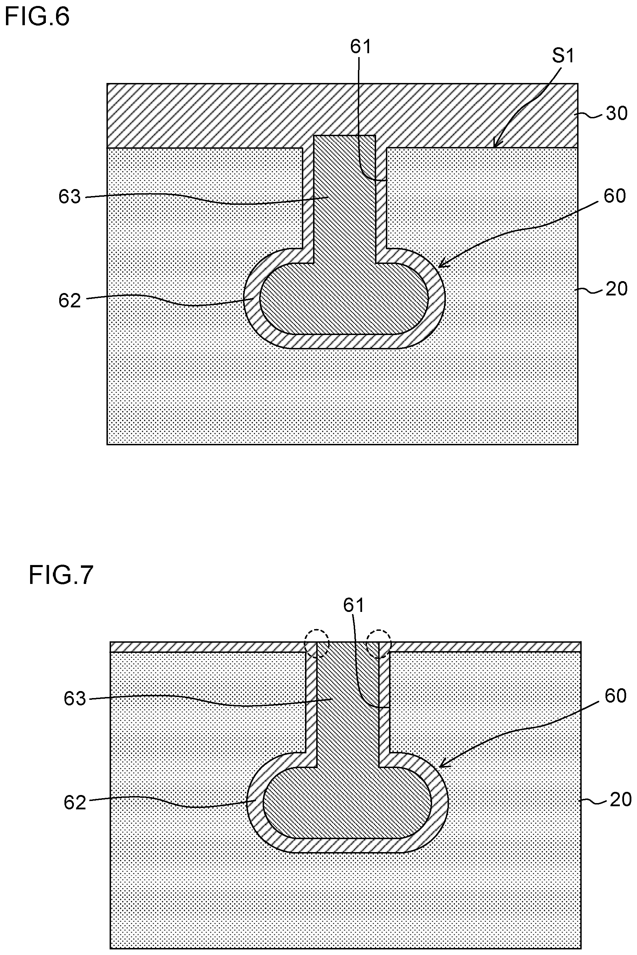

Fig. 6 is an enlarged cross-sectional view illustrating the anchor structure portion 60. The anchor structure portion 60 includes a conductive film 62 made of a superconductor that covers an inner wall of a hole 61 provided on the first surface S1 side of the substrate 20, and a conductive film 63 that is in contact with the conductive film 62 and is filled in the hole 61. The conductive film 62 is made of a superconductor such as TiN. The conductive film 63 is made of a metal that can be formed by a plating method such as Au, Ag, or Cu. The conductive film 62 is an example of a "second conductive film" in the disclosed technology. The conductive film 63 is an example of a "third conductive film" in the disclosed technology.

In order to uniformly cover the inner wall of the hole 61 with the conductive film 62, the conductive film 62 is preferably formed by a vapor deposition method such as chemical vapor deposition (CVD) or atomic layer deposition (ALD). The ALD method is more preferable for securing the denseness and thickness uniformity of the conductive film 62. In general, since a film formed by a vapor deposition method has a low film formation rate, it is difficult to fill the hole 61 only with the conductive film 62. Therefore, the inside of the hole 61 may be filled with the conductive film 63 formed by a plating method.

The opening end of the hole 61 is covered with the conductive film 30 provided on the first surface S1 of the substrate 20. As illustrated in Fig. 7, in a case in which the opening end of the hole 61 is not covered, the interface between the conductive film 62 and the conductive film 63 constituting the anchor structure portion 60 is exposed. A region surrounded by a dotted line in Fig. 7 is a region where an interface between the conductive film 62 and the conductive film 63 is exposed. In a case in which the interface between the conductive film 62 and the conductive film 63 is exposed, a battery effect may occur at the interface in a subsequent process, and the conductive film having a lower natural potential among the conductive film 62 and the conductive film 63 may be corroded. By covering the opening end of the hole 61 with the conductive film 30 not to expose the interface between the conductive film 62 and the conductive film 63, it becomes possible to prevent the occurrence of a corrosion potential at the contact interface between the conductive film 62 and the conductive film 63, and it becomes possible to prevent corrosion of the conductive films constituting the anchor structure portion 60.

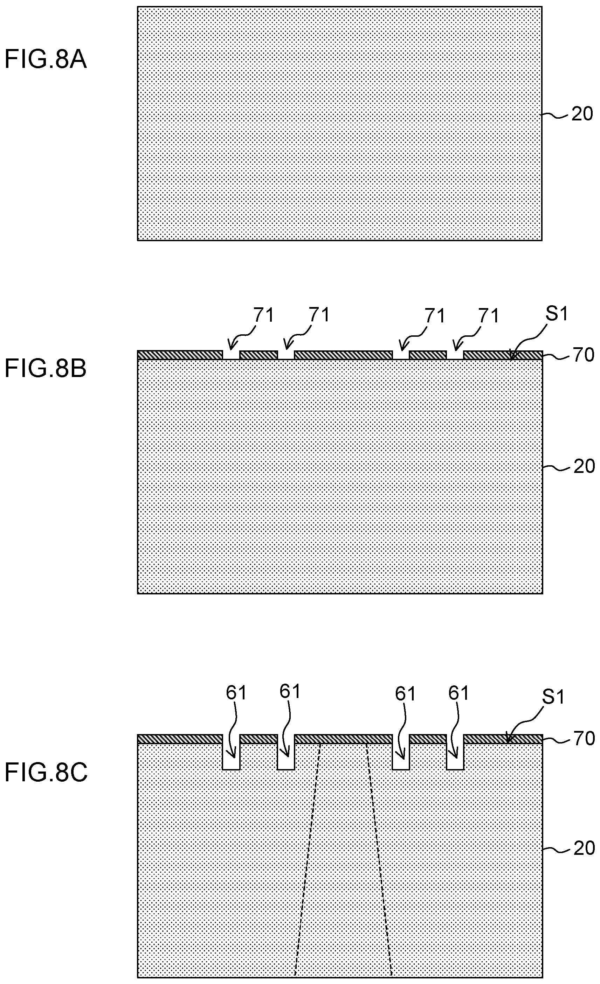

Hereinafter, a manufacturing method of the quantum bit device 10 will be described. Figs. 8A to 8M are cross-sectional views illustrating an example of the manufacturing method of the quantum bit device 10. Figs. 8A to 8J illustrate only the peripheral structure of one through via 50 or the intended formation position thereof. First, the substrate 20 is prepared. As the substrate 20, for example, a silicon substrate can be used (Fig. 8A). As the substrate 20, a semiconductor substrate or an insulator substrate other than a silicon substrate can also be used.

Next, a mask 70 for forming the hole 61 of the anchor structure portion 60 is formed on the first surface S1 of the substrate 20 (Fig. 8B). The mask 70 has an opening portion 71 at an intended formation position of the hole 61. For example, Al can be used as the material of the mask 70. For example, an Al film is formed on the first surface S1 of the substrate 20 by electron beam (EB) evaporation, and the mask 70 is formed by patterning the Al film through photolithography and wet etching.

Next, the first surface S1 of the substrate 20 is etched through the mask 70 by dry etching using, for example, a CF₄ gas. The dry etching is preferably performed under a condition of a pressure of 50 Pa or less. This dry etching is anisotropic etching, and by this dry etching, the hole 61 having a rectangular cross-sectional shape is formed in the surface layer portion on the first surface S1 side of the substrate 20 (Fig. 8C). The hole 61 is formed around an intended formation position of the through via 50 (indicated by a dotted line in Figs. 8C to 8H).

Next, a mask 71 that covers the entire second surface S2 of the substrate 20 is formed. For example, Al can be used as the material of the mask 71. For example, the mask 71 is formed by forming an Al film on the second surface S2 of the substrate 20 by the EB evaporation.

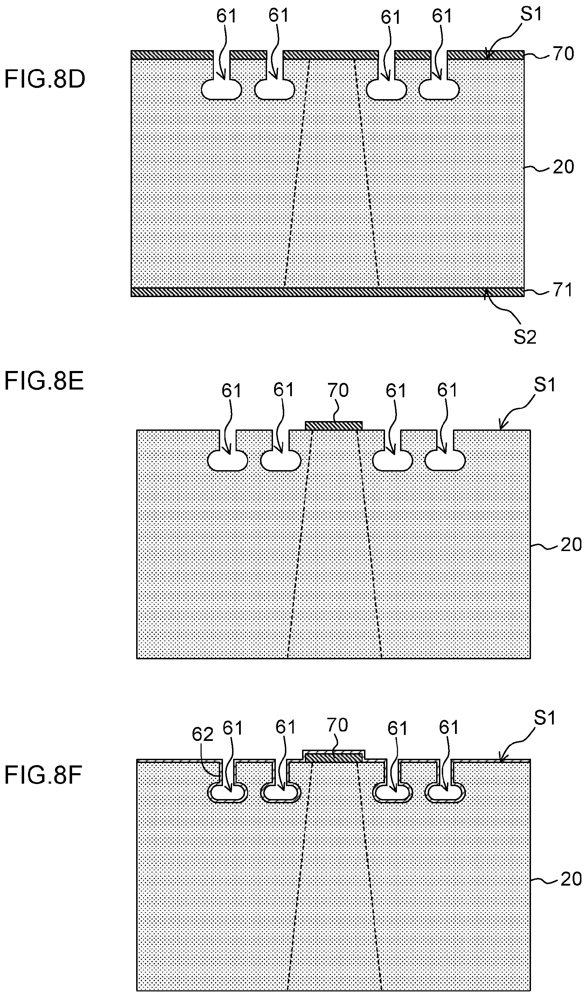

Subsequently, the first surface S1 of the substrate 20 is etched through the mask 70 by wet etching using an etching solution obtained by diluting a hydrofluoric-nitric acid with acetic acid. By this wet etching, the bottom portion of the previously formed rectangular hole 61 is further etched. This wet etching is isotropic etching, and the shape of the hole 61 becomes an overhang shape in which a width on a deep side of the substrate 20 is greater than a width on a surface layer side of the substrate 20 (Fig. 8D). As the material of the masks 70 and 71, a material other than Al having resistance to the above-described dry etching and wet etching can also be used.

Next, the mask 71 formed on the second surface S2 of the substrate 20 is removed by photolithography and wet etching, and the mask 70 formed on the first surface S1 of the substrate 20 is patterned (Fig. 8E). The mask 70 is patterned to leave a portion corresponding to the intended formation position of the through via 50. The mask 70 functions as an etching stop layer in etching performed when the through via 50 is formed. The etching stop layer is used as necessary, and the mask 70 may be removed in this process when unnecessary.

Next, the conductive film 62 made of a superconductor that covers the inner wall of the hole 61 and the first surface S1 of the substrate 20 is formed by a vapor deposition method (Fig. 8F). For example, the conductive film 62 containing TiN is formed using TiCl₄ and NH₃ as raw materials. As the vapor deposition method, a CVD method or an ALD method can be used. The ALD method is more preferable for securing the denseness and thickness uniformity of the conductive film 62. Subsequently, a resist mask (not illustrated) having an opening portion at a formation position of the hole 61 is formed on the first surface S1 of the substrate 20, and the surface treatment of the conductive film 62 is performed via the resist mask. This surface treatment is, for example, plasma cleaning using Ar gas, and the surface of the conductive film 62 is cleaned by this surface treatment.

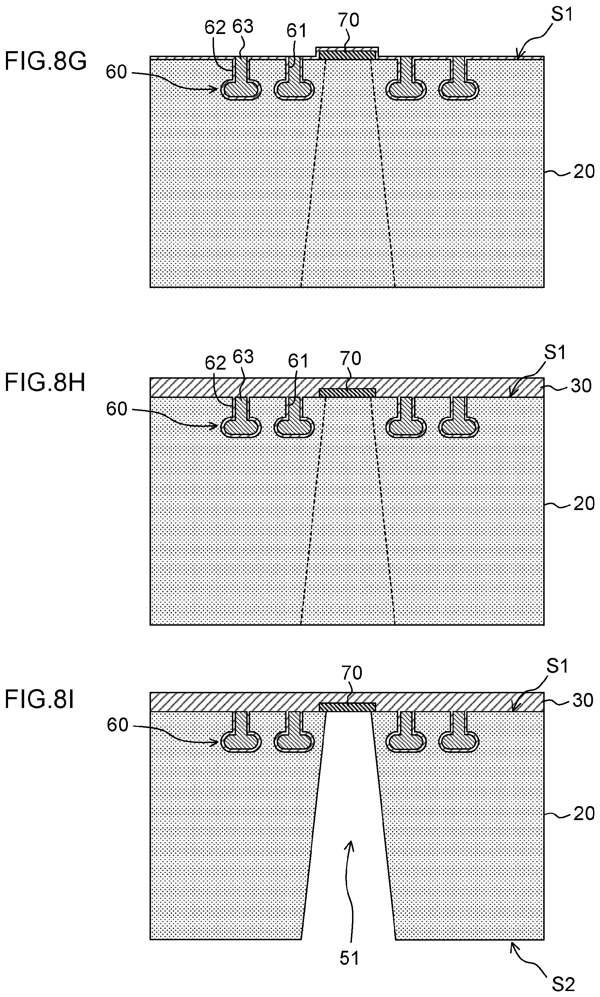

Next, the conductive film 63 that fills the hole 61 is formed by an electroplating method. The conductive film 63 is formed adjacent to the previously formed conductive film 62. As a material of the conductive film 63, a metal that can be formed by an electroplating method, such as Au, Ag, or Cu, can be used. By filling the hole 61 with the conductive films 62 and 63, the anchor structure portion 60 is formed in the substrate 20 in a region around an intended formation position of the through via 50 (see Fig. 8G). In general, since a film formed by a vapor deposition method has a low film formation rate, it is difficult to fill the hole 61 only with the conductive film 62. By filling the hole 61 with the conductive film 63 formed by an electroplating method, the processing time for forming the anchor structure portion 60 can be shortened.

Next, the conductive film 30 made of a superconductor that covers the entire first surface S1 of the substrate 20 is formed by a sputtering method (Fig. 8H). The opening end of the hole 61 of the anchor structure portion 60 is covered with the conductive film 30. As a result, the interface between the conductive film 62 and the conductive film 63 is not exposed. As a result, it is possible to prevent occurrence of a battery effect at the interface between the conductive film 62 and the conductive film 63, and it is possible to prevent corrosion of the conductive film constituting the anchor structure portion 60. The thickness of the conductive film 30 is sufficiently larger than the thickness of the conductive film 62. For example, the thickness of the conductive film 62 is on the order of several nanometers, whereas the thickness of the conductive film 30 is on the order of several microns. The conductive film 62 and the conductive film 30 may be configured of the same material, and in this case, a portion of the conductive film 62 covering the first surface S1 of the substrate 20 is integrated with the conductive film 30.

Next, a resist mask (not illustrated) having an opening portion at an intended formation position of the through via 50 is formed on the second surface S2 of the substrate 20. Subsequently, the substrate 20 is etched from the side of the second surface S2 via the resist mask by deep reactive ion etching (DRIE) to form the through hole 51 reaching from the second surface S2 to the first surface S1 of the substrate 20. The mask 70 formed on the first surface S1 of the substrate 20 functions as an etching stop layer (Fig. 8I). After the formation of the through hole 51, the mask 70 is removed.

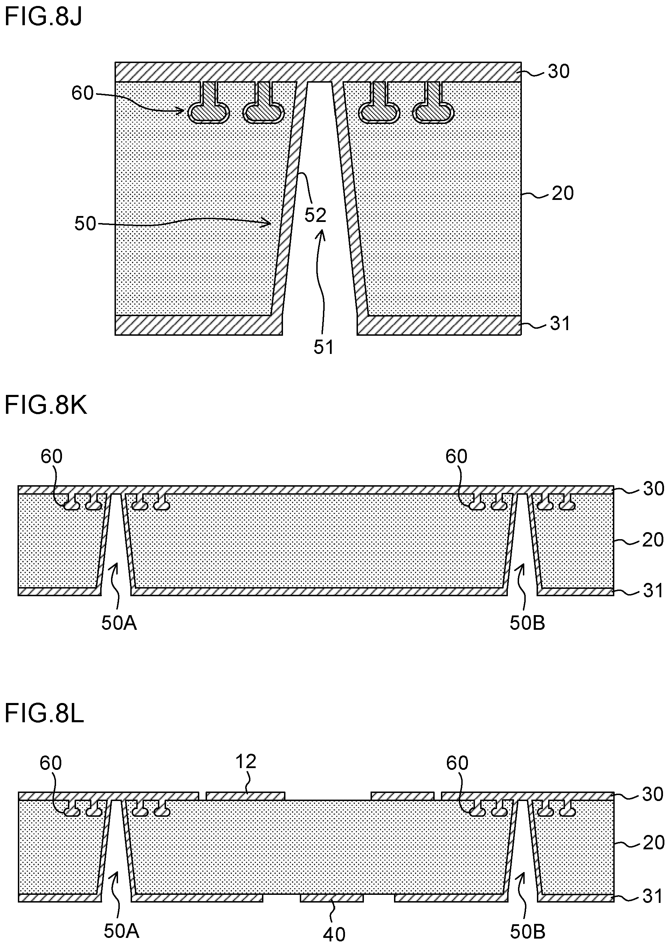

Next, the conductive film 52 made of a superconductor that covers the inner wall of the through hole 51 and the second surface S2 of the substrate 20 is formed by the vapor deposition method (Fig. 8J). The conductive film 52 containing TiN is formed using TiCl₄ and NH₃ as raw materials. The through via 50 is formed by forming the conductive film 52. As the vapor deposition method, a CVD method or an ALD method can be used. The ALD method is more preferable for securing the denseness and thickness uniformity of the conductive film 52. Next, the conductive film 31 made of a superconductor such as TiN that covers the entire second surface S2 of the substrate 20 is formed by a sputtering method. The conductive film 52 and the conductive film 31 may be made of the same material, and in this case, a portion of the conductive film 52 covering the second surface S2 of the substrate 20 is integrated with the conductive film 31.

In Fig. 8K, a general-purpose substrate used for producing the quantum bit device 10 manufactured through the above processes is shown.

After the general-purpose substrate is produced, the conductive film 30 formed on the first surface S1 of the substrate 20 and the conductive film 31 formed on the second surface S2 of the substrate 20 are patterned by photolithography and wet etching. As a result, the resonator 12 and various wirings are formed on the first surface S1 of the substrate 20, and the control electrode 40 and various wirings are formed on the second surface S2 of the substrate 20 (Fig. 8L).

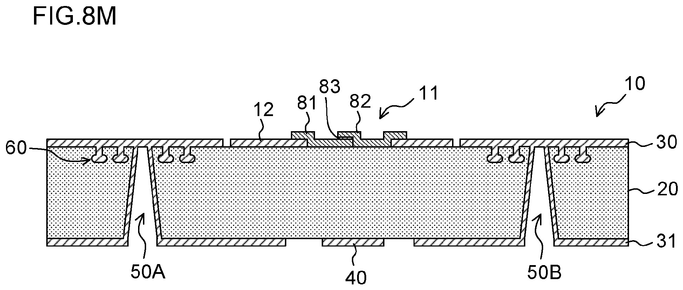

Next, the quantum bit 11 is formed on the first surface S1 of the substrate 20 (Fig. 8M). The Josephson device configuring the quantum bit 11 is formed through, for example, a process of forming a first electrode 81 containing Al on the first surface S1 of the substrate 20 by a vapor deposition method, a process of forming an ultrathin oxide film 83 having a thickness of about several nm on the surface of the first electrode 81 using an O₂ gas, and a process of forming a second electrode 82 containing Al on the surface of the oxide film by a vapor deposition method. Patterning of the first electrode 81 and the second electrode 82 may be performed by, for example, a lift-off method using a patterned resist (not illustrated). In this case, the opening pattern of the resist may have a cross shape including a first straight line portion along a first direction and a second straight line portion along a second direction orthogonal to the first direction, and the first electrode 81 may be formed at a portion corresponding to the first straight line portion by performing vapor deposition while inclining the first direction as a rotation axis. Subsequently, the second electrode 82 may be formed in a portion corresponding to the second straight line portion by performing vapor deposition while inclining the second direction as the rotation axis. According to the above method, it is possible to pattern the first electrode 81 and the second electrode 82 with a single resist. The quantum bit device 10 is completed through the above processes.

As described above, the quantum bit device 10 according to the embodiment of the disclosed technology includes the substrate 20, the quantum bit 11 provided on the first surface S1 of the substrate 20, the conductive film 30 provided on the first surface S1 of the substrate 20, and the through via 50 penetrating the substrate 20 and electrically connected to the conductive film 30. The quantum bit device 10 is provided around the through via 50 inside the substrate 20 and has the anchor structure portion 60 connected to the conductive film 30.

By connecting the anchor structure portion 60 to the periphery of the portion of the conductive film 30 that covers the opening end of the through via 50, bonding between the conductive film 30 and the substrate 20 is strengthened, and peeling of the conductive film 30 is suppressed. Since the anchor structure portion 60 has the overhang shape, the bonding between the conductive film 30 and the substrate 20 can be further strengthened. In addition, a technology of forming a parylene layer on an inner wall of a through hole of a through via in order to suppress the upward force (see Fig. 4) acting on the portion of the conductive film that covers the opening end of the through via is known. However, it is difficult for the parylene layer to prevent film formation in an unnecessary portion. According to the quantum bit device 10 according to the present embodiment, it is possible to suppress peeling of the conductive film 30 without forming a parylene layer.

In addition, according to the quantum bit device 10 according to the present embodiment, the opening end of the through hole 51 of the through via 50 on the first surface S1 side is covered with the conductive film 30. As a result, the surface of the substrate 20 is planarized, and the film thickness of the resist when the wiring or the quantum bit 11 is patterned can be made uniform. As a result, it is possible to suppress the characteristic variation of the quantum bit 11.

### REFERENCE SIGNS LIST

- 10: Quantum bit device
- 11: Quantum bit
- 12: Resonator
- 20: Substrate
- 30, 31, 52, 62, 63: Conductive film
- 31: Conductive film
- 40: Control electrode
- 50: Through via
- 50A: Through via
- 50B: Through via
- 51: Through hole
- 52: Conductive film
- 60: Anchor structure portion
- 61: Hole

## Claims

1. A quantum bit device comprising:
a substrate;
a quantum bit provided on a first surface of the substrate;
a first conductive film provided on the first surface of the substrate;
a through via that penetrates the substrate and is electrically connected to the first conductive film; and
an anchor structure portion provided in the substrate around the through via and connected to the first conductive film.

2. The quantum bit device according to claim 1, wherein
an end portion of the through via on a side of the first surface is covered with the first conductive film.

3. The quantum bit device according to claim 1, wherein
the anchor structure portion includes
a second conductive film made of a superconductor that covers an inner wall of a hole provided on a side of the first surface of the substrate, and
a third conductive film that is in contact with the second conductive film and is filled in the hole, and
an opening end of the hole is covered with the first conductive film.

4. The quantum bit device according to claim 1, wherein
the anchor structure portion has an overhang shape in which a width on a deep side of the substrate is greater than a width on a surface layer side of the substrate.

5. The quantum bit device according to claim 1, wherein
a shape of the anchor structure portion in plan view is circular.

6. The quantum bit device according to claim 1, wherein
a plurality of the anchor structure portions are provided in an arrangement surrounding a periphery of the through via.

7. The quantum bit device according to claim 1, wherein
a shape of the anchor structure portion in plan view is an annular shape surrounding a periphery of the through via.

8. The quantum bit device according to any one of claims 1 to 7, wherein
the through via has a fourth conductive film made of a superconductor that covers an inner wall of a through hole penetrating the substrate, and
the first conductive film is made of a superconductor.

9. A manufacturing method of a quantum bit device, the method comprising:
a process of forming an anchor structure portion in a substrate in a region around an intended formation position of a through via formed in the substrate;
a process of forming a first conductive film on a first surface of the substrate, the first conductive film being connected to the anchor structure portion;
a process of forming a through hole from a second surface of the substrate to reach the first surface;
a process of forming the through via that penetrates the substrate and is electrically connected to the first conductive film; and
a process of forming a quantum bit on the first surface of the substrate.

10. The manufacturing method according to claim 9, wherein
the process of forming the anchor structure portion includes
a process of forming a hole in a region around the intended formation position of the through via on the first surface of the substrate,
a process of forming a second conductive film made of a superconductor that covers an inner wall of the hole, and
a process of forming a third conductive film that is in contact with the second conductive film and is filled in the hole, and
the first conductive film is formed to cover an opening end of the hole.

11. The manufacturing method according to claim 10, wherein
the second conductive film is formed using a vapor deposition method, and
the third conductive film is formed using a plating method.

12. The manufacturing method according to claim 11, wherein
the second conductive film is formed using atomic layer deposition.

13. The manufacturing method according to claim 9, wherein
the anchor structure portion has an overhang shape in which a width on a deep side of the substrate is greater than a width on a surface layer side of the substrate.

14. The manufacturing method according to claim 9, wherein
an opening end of the through via on a side of the first surface is covered with the first conductive film.

15. The manufacturing method according to claim 9, wherein
a shape of the anchor structure portion in plan view is circular.

16. The manufacturing method according to claim 9, wherein
a plurality of the anchor structure portions are provided in an arrangement surrounding a periphery of the through via.

17. The manufacturing method according to claim 9, wherein
the anchor structure portion has an annular shape that surrounds a periphery of the through via.

18. The manufacturing method according to any one of claims 9 to 17, wherein
the through via has a fourth conductive film made of a superconductor covering an inner wall of a through hole penetrating the substrate, and
the first conductive film is made of a superconductor.
